# EUROPÄISCHE PATENTSCHRIFT

(11) **EP 1 470 743 B1**
(45) Veröffentlichungstag und Bekanntmachung des Hinweises auf die Patenterteilung: **11.01.2006**
(21) Anmeldenummer: 02790452.3
(22) Anmeldetag: 28.11.2002
(51) Int. Cl.: H05K 1/02

(54) **LEISTUNGSMODUL**
POWER MODULE
MODULE DE PUISSANCE

(30) Priorität: 01.02.2002 DE 10204200
(43) Veröffentlichungstag der Anmeldung: 27.10.2004
(73) Patentinhaber: Conti Temic microelectronic GmbH, 90411 Nürnberg (DE)
(72) Erfinder: BÄUMEL, Hermann, 92318 Neumarkt (DE); GRAF, Werner, 90482 Nürnberg (DE); KILIAN, Hermann, 91456 Diespeck (DE); WAGNER, Bernhard, 90489 Nürnberg (DE); GEORGE, Dietrich, 95445 Bayreuth (DE); BRIGGS, William, T., Livonia, MI 48154 (US)
(86) Internationale Anmeldenummer: PCT/EP2002/013423
(87) Internationale Veröffentlichungsnummer: WO 2003/065469

(56) Entgegenhaltungen:
- DE-A- 19 735 074
- US-A- 5 134 094
- US-A- 5 966 291
- US-A- 6 166 464
- US-A1- 2002 008 967

## Beschreibung

In vielen Bereichen werden elektronische Baugruppen für unterschiedliche Aufgaben und Anwendungen eingesetzt; insbesondere sind bei einem hohen Leistungsbedarf der elektronischen Baugruppe (d.h. bei einem Leistungsbedarf im kW-Bereich) als Leistungsmodule ausgebildete elektronische Baugruppen zu Ansteuerzwecken gebräuchlich, beispielsweise zur Drehzahl- und Leistungsregelung von Elektromotoren. Diese oftmals mit hohen Versorgungsspannungen oberhalb des Niedervoltbereichs (d.h. mit Versorgungsspannungen > 60 V) betriebenen Leistungsmodule benötigten Bauteile zum Verarbeiten und Speichern der im Betrieb des Leistungsmoduls anfallenden hohen Energiemengen sowie zur Signalleitung von Steuersignalen und/oder Meßsignalen; insbesondere sind daher sowohl aktive Bauteile wie im Schaltbetrieb mit hohen Stromänderungsgeschwindigkeiten arbeitende Leistungsbauteile (Leistungsschalter zum Schalten großer Lasten) als auch passive Bauteile wie Widerstände (bsp. Shunts zur Strommessung) und mindestens ein Kondensator zur Energiespeicherung und zur Glättung der Versorgungsspannung vorgesehen. Zur Realisierung eines induktionsarmen Aufbaus (Vermeidung von Überspannungen) werden die Leistungsbauteile üblicherweise auf mindestens einen isolierenden Trägerkörper (mindestens ein isolierendes Substrat) aufgebracht, der in der Regel aus einem keramischen Material besteht. Zur mechanischen Stabilisierung und zur Wärmeabfuhr der Verlustleistung der Bauteile des Leistungsmoduls (insbesondere der Leistungsbauteile) wird der mindestens eine Trägerkörper auf einen bsp. an ein Kühlsystem mit einem Kühlkreislauf angeschlossenen metallischen Kühlkörper (bsp. eine Kupferplatte oder Aluminiumplatte) aufgebracht und an diesen thermisch angebunden. Das Leistungsmodul ist üblicherweise mit weiteren Bauteilen oder Baugruppen zur Spannungsversorgung und/oder zur Signalleitung über mindestens einen Anschlußstecker verbunden.
Für verschiedene Betriebszustände des Leistungsmoduls, bsp. beim Abziehen von Anschlußsteckern im Wartungsfall, ist es aus Sicherheitsgründen erforderlich, die im Leistungsmodul vorhandene Spannung rasch möglichst auf ein ungefährliches (insbesondere auf ein nicht lebensbedrohendes) Potential abzusenken; folglich sollte die im Leistungsmodul gespeicherte hohe Energiemenge innerhalb kurzer Zeit abgeführt (vernichtet) werden, d.h. der zur Energiespeicherung herangezogene mindestens eine Kondensator sollte bei Bedarf schnell entladen werden können.

Der Erfindung liegt die Aufgabe zugrunde, ein auf einfache Weise mit geringen Kosten herstellbares Leistungsmodul mit einem einfachen Aufbau, vorteilhaften thermischen Eigenschaften, einer hohen Zuverlässigkeit und einer hohen Betriebssicherheit anzugeben.
Diese Aufgabe wird nach der Erfindung durch die Merkmale im Kennzeichen des Patentanspruchs 1 gelöst.
Vorteilhafte Ausgestaltungen der Erfindung sind Bestandteil der übrigen Patentansprüche.

Zur Gewährleistung einer hohen Betriebssicherheit in allen Betriebszuständen des Leistungsmoduls weist das Leistungsmodul eine über ein Schaltelement aktivierbare Entladeschaltung auf, durch die im Bedarfsfall nach deren Aktivierung die in mindestens einem Bauteil als Energiespeicher (insbesondere in mindestens einem Kondensator) gespeicherte Energie in einem Entladevorgang über einen Entladewiderstand abgeführt wird, der in Form von mindestens einem Dickschichtwiderstand realisiert ist; der mindestens eine Dickschichtwiderstand ist in einer als Dickschichtschaltung ausgebildeten Hybridschaltung auf mindestens einem der zur Aufnahme der Leistungsbauteile vorgesehenen Trägerkörper angeordnet. In Abhängigkeit der beim Entladevorgang abzuführenden Energiemenge und damit der hieraus resultierenden Verlustleistung ergibt sich ein bestimmter Widerstandswert für den Entladewiderstand; je nach Widerstandswert und damit benötigtem Flächenbedarf für den Entladewiderstand kann dieser Entladewiderstand in mehrere parallel geschaltete, jeweils als Dickschichtwiderstände ausgebildete Teilwiderstände unterteilt werden, die in mindestens einer als Dickschichtschaltung ausgebildeten Hybridschaltung an einer geeigneten Stelle auf mindestens einem Trägerkörper angeordnet sind. Somit wird die gesamte abzuführende Verlustleistung auf alle parallel geschalteten Teilwiderstände entsprechend deren Widerstandswert aufgeteilt und damit der auf jeden Teilwiderstand entfallende Anteil gegenüber der gesamten abzuführenden Verlustleistung reduziert; bsp. wird bei einer Unterteilung des Entladewiderstands in mehrere Teilwiderstände mit gleichen Widerstandswerten die gesamte abzuführende Verlustleistung auf alle parallel geschalteten Teilwiderstände zu gleichen Teilen aufgeteilt. Bei einer Unterteilung des Entladewiderstands in mehrere Teilwiderstände können diese Teilwiderstände bei einem mehrere Trägerkörper für die Leistungsbauteile aufweisenden Leistungsmodul je nach auf den Trägerkörpern zur Verfügung stehenden Flächen und je nach Flächenbedarf der Teilwiderstände entweder in einer Hybridschaltung oder in mehreren Hybridschaltungen entweder auf einem Trägerkörper oder auf mehreren Trägerkörpern angeordnet werden; insbesondere kann auf jedem Trägerkörper eine Hybridschaltung als Dickschichtschaltung angeordnet werden, die jeweils einen Teilwiderstand des Entladewiderstands als Dickschichtwiderstand aufweist.
Den den mindestens einen Dickschichtwiderstand aufnehmenden Hybridschaltungen können weitere Bauteile zugeordnet werden, insbesondere das vorzugsweise als Schalttransistor (bsp. als MOSFET) ausgebildete Schaltelement zur Aktivierung der Entladeschaltung und/oder Sensoren des Leistungsmoduls, bsp. mindestens ein Temperatursensor zur thermischen Überwachung der Leistungsbauteile.
Der mindestens eine Trägerkörper zur Aufnahme der Leistungsbauteile und der Hybridschaltungen besteht aus einem isolierendem Material mit hoher Wärmeleitfähigkeit, insbesondere als Keramikträgerkörper (Keramiksubstrat) aus einem keramischen Material, bsp. aus Aluminiumoxid Al₂O₃ oder Aluminiumnitrid AIN. Auf die Oberseite des Trägerkörpers wird eine (metallische) Leiterbahnstruktur mit Leiterbahnen, Aufnahmeflächen, Kontaktierungsstellen und Anschlußflächen direkt aufgebracht (d.h. ohne Zwischenschichten auf die Oberfläche des Trägerkörpers), insbesondere durch das DCB-Verfahren "(Direct Copper Bonding") oder durch Aktivlötung ("Active Metal Bonding"). Auf die Aufnahmeflächen der Leiterbahnstruktur werden Bauteile, insbesondere die bsp. in Form von Silizium-Chips ausgebildeten Leistungsbauteile aufgebracht (bsp. mittels Weichlot aufgelötet oder aufgepreßt), die miteinander und/oder mit der Leiterbahnstruktur ggf. über Kontaktierungselemente kontaktiert werden, insbesondere mittels Drahtbonden durch Kontaktierung der Anschlüsse der Bauteile über als Bonddrähte ausgebildete Kontaktierungselemente mit Kontaktierungsstellen der Leiterbahnstruktur oder mit Anschlüssen weiterer Bauteile. Die Hybridschaltungen werden auf dem hierfür vorgesehenen Trägerkörper in Abhängigkeit des Platzbedarfs an einer geeigneten Stelle aufgebracht, bsp. durch Kleben oder Weichlöten. Die Anschlußflächen der Leiterbahnstruktur werden mit Anschlußkontakten (bsp. mit Anschlußpins) ggf. über Kontaktierungselemente verbunden; an die Anschlußkontakte können Anschlußstecker zur Spannungsversorgung des Leistungsmoduls und/oder zur Verbindung des Leistungsmoduls mit weiteren Baugruppen oder Bauteilen angeschlossen werden. Die (bsp. ganzflächig mit einer Metallisierungsschicht versehene) Unterseite des mindestens einen Trägerkörpers wird auf einen Kühlkörper aus einem Material mit hoher Wärmeleitfähigkeit aufgebracht (insbesondere wird der mindestens eine Trägerkörper auf den Kühlkörper aufgelötet), über den letztendlich die Wärmeabfuhr der Verlustleistung der Bauteile des Leistungsmoduls erfolgt; der Kühlkörper ist insbesondere an ein Kühlsystem angeschlossen, bsp. in einen Kühlkreislauf des Kühlsystems integriert, so daß der Kühlkörper vom Kühlmittel des Kühlkreislaufs (insbesondere von Wasser oder von Luft) umströmt wird.

Das Leistungsmodul vereinigt mehrere Vorteile in sich:
Mindestens ein Trägerkörper dient gleichzeitig als Substrat für Bauteile und für mindestens eine Hybridschaltung; durch die unmittelbare Anbindung der Hybridschaltung und damit des mindestens einen Dickschichtwiderstands zur Realisierung des Entladewiderstands über den jeweiligen Trägerkörper an das Kühlsystem (insbesondere an einen Kühlkörper und ggf. an einen Kühlkreislauf) wird eine gute thermische Anbindung des mindestens einen Dickschichtwiderstands und damit aller Leistungsbauteile des Leistungsmoduls ermöglicht und eine gute Wärmeabfuhr (Abfuhr der Verlustleistung) realisiert, so daß eine hohe Zuverlässigkeit und Lebensdauer des Leistungsmoduls gegeben ist.
Durch die Ausbildung der Dickschichtwiderstände (insbesondere durch Festlegung der Geometrie der Dickschichtwiderstände) kann der Widerstandswert des Entladewiderstands und der Teilwiderstände und damit die abführbare Verlustleistung variabel an die Anforderungen angepaßt werden; insbesondere kann eine geeignete Unterteilung des Entladewiderstands in Teilwiderstände entsprechend der auf dem jeweiligen Trägerkörper zur Aufnahme von Hybridschaltungen und damit auch für die Dickschichtwiderstände zur Verfügung stehenden Fläche gewählt werden, wodurch der insgesamt für das Leistungsmodul benötigte Platzbedarf gering gehalten werden kann, insbesondere wenn in den Hybridschaltungen noch weitere Bauteile je nach Platzbedarf und Funktionalität eingebunden werden.
Der Herstellungsaufwand ist gering, da eine einfache Herstellung der Hybridschaltung als Dickschichtschaltung mit Standardverfahren möglich ist (insbesondere auch durch den Einsatz einfacher und kostengünstiger Materialien) und da die Kontaktierung der Dickschichtwiderstände mittels einer auch bei den übrigen Bauteilen des Leistungsmoduls eingesetzten Kontaktierungsmethode im gleichen Verfahrensschritt mit den gleichen Kontaktierungselementen erfolgen kann, bsp. durch Drahtbonden mit Bonddrähten.

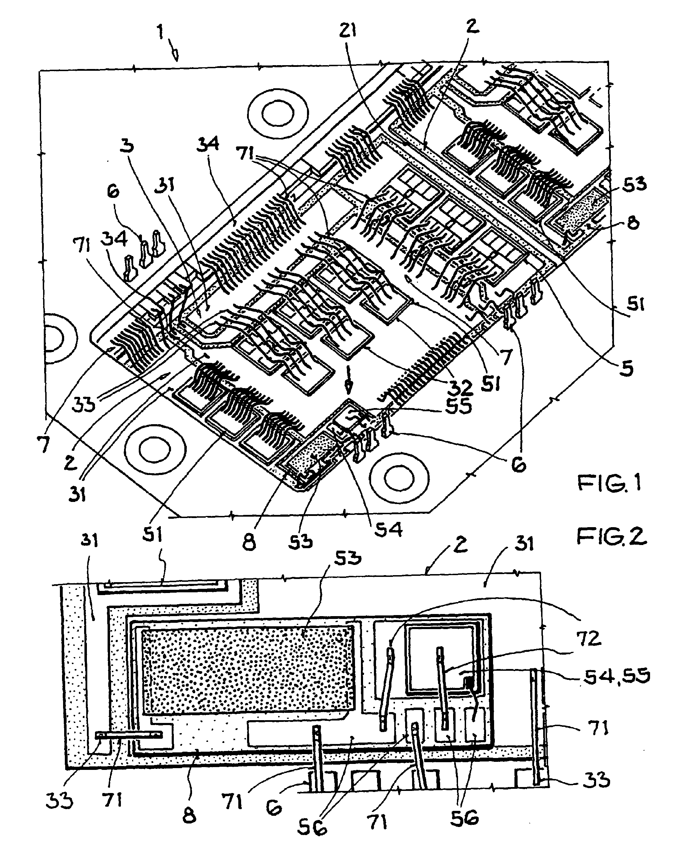

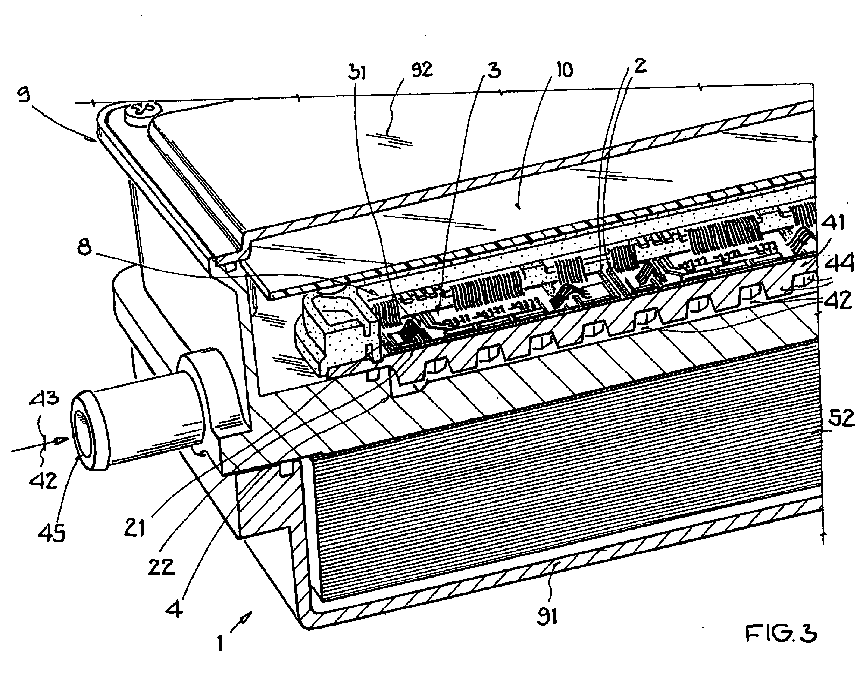

Im Zusammenhang mit der Zeichnung (Figuren 1 bis 3) soll das Leistungsmodul anhand eines Ausführungsbeispiels erläutert werden. Hierbei zeigen:
- Figur 1: in einem Ausschnitt eine Draufsicht auf die Oberseite des Leistungsmoduls,
- Figur 2: eine der Hybridschaltungen des Leistungsmoduls in einem vergrößerten Ausschnitt der Figur 1,
- Figur 3: eine Schnittdarstellung des Leistungsmoduls.

Das Leistungsmodul 1 wird bsp. als Leistungsumrichter für flüssigkeitsgekühlte Elektromotoren im Kraftfahrzeugbereich eingesetzt (Leistung bsp. 10 kW); aufgrund der hohen Verlustleistung im Betrieb des Leistungsumrichters 1 wird der Leistungsumrichter 1 beispielsweise direkt am Elektromotor an dessen Kühlsystem 4 angekoppelt.

Mehrere aus einem keramischen Material (bsp. aus AIN) bestehende Trägerkörper 2 (Keramiksubstrate) des Leistungsumrichters 1 mit den Abmessungen von jeweils bsp. 65 mm x 42 mm x 1.3 mm sind hintereinander auf dem Kühlkörper 41 des Kühlsystems 4 angeordnet; bsp. sind drei Keramiksubstrate als Trägerkörper 2 hintereinander auf dem Kühlkörper 41 angeordnet. Weiterhin ist eine Leiterplatte 10 als Trägerkörper für Bauteile einer zur Ansteuerung vorgesehenen Steuereinheit des Leistungsumrichters 1 vorgesehen.
Auf die Oberseite 21 der Trägerkörper 2 ist jeweils eine bsp. aus Kupfer bestehende Leiterbahnstruktur 3 (Dicke bsp. 0.3 mm) mit Leiterbahnen 31, Aufnahmeflächen 32, Kontaktierungsstellen 33 und Anschlußflächen 34 aufgebracht, bsp. mittels des DCB-Verfahrens auf die Trägerkörper 2 aufgelötet. An bestimmten Kontaktierungsstellen 33 der Leiterbahnstruktur 3 werden die Bauteile 5 mit der Leiterbahnstruktur 3 kontaktiert, d.h. mit Leiterbahnen 31 und/oder mit Anschlußflächen 34 der Leiterbahnstruktur 3 elektrisch leitend über Kontaktierungselemente 7 verbunden, bsp. über Bonddrähte 71; bestimmte Anschlußflächen 34 der Leiterbahnstruktur 3 münden in bsp. als Anschlußpins ausgebildete Anschlußkontakte 6.
Als Bauteile 5 des Leistungsumrichters 1 sind Leistungsbauteile 51 zur Realisierung der Umrichterfunktion und der sich hieraus ergebenden Ansteuerung des Elektromotors, ein Kondensator 52 zur Energiespeicherung und zur Glättung der Versorgungsspannung und ein Temperatursensor 54 zur thermischen Überwachung der Leistungsbauteile 51 vorgesehen sowie als Bauteile einer Entladeschaltung des Leistungsumrichters 1 ein Entladewiderstand zum raschen Entladen der im Kondensator 52 gespeicherten Energie in einem Entladevorgang und ein Schalttransistor 55 zur Aktivierung des Entladevorgangs. Die Leistungsbauteile 51 werden bsp. als Silizium-Chips an bestimmten Aufnahmeflächen 32 auf die Leiterbahnstruktur 3 aufgebracht (bsp. mittels eines Weichlötprozesses aufgelötet) und bsp. über Bonddrähte 71 als Kontaktierungselemente 7 mit Kontaktierungsstellen 33 der Leiterbahnen 31 der Leiterbahnstruktur 3 und/oder mit Anschlußflächen 34 der Leiterbahnstruktur 3 und/oder mit anderen Bauteilen 5 verbunden. Zur extemen Verbindung des Leistungsumrichters 1, insbesondere zur Spannungsversorgung und zur Signalleitung von Steuersignalen, können an die als Anschlußpins ausgebildeten Anschlußkontakte 6 Anschlußstecker angebracht werden, insbesondere zur Verbindung des Leistungsumrichters 1 mit einer Spannungsquelle und/oder mit den Motorphasenanschlüssen des Elektromotors. Auf jedem der Trägerkörper 2 ist eine Hybridschaltung 8 als Dickschichtschaltung aufgebracht, wobei jede der Hybridschaltungen 8 zumindest einen Dickschichtwiderstand 53 als Teilwiderstand des Entladewiderstands aufweist. Bsp. sind demnach für die drei Trägerkörper 2 (DCB-Substrate) drei Hybridschaltungen 8 vorgesehen, wobei eine der Hybridschaltungen 8 neben dem Dickschichtwiderstand 53 noch den als Chip ausgebildeten Schalttransistor als Schaltelement 55 (bsp. ein MOSFET) und eine der Hybridschaltungen 8 neben dem Dickschichtwiderstand 53 noch den als Temperatursensor ausgebildeten Sensor 54 aufweist.
Die (interne) Kontaktierung innerhalb der jeweiligen Hybridschaltung 8, d.h. die Kontaktierung des Dickschichtwiderstands 53 auf der jeweiligen Hybridschaltung 8, des Schalttransistors 55 und des Temperatursensors 54, erfolgt entweder direkt über die auf der jeweiligen Hybridschaltung 8 aufgedruckten Dickschichtleiterbahnen 56 oder durch Drahtbonden mittels Bonddrähten 72 zwischen Dickschichtwiderstand 53, Schalttransistor 55, Temperatursensor 54 einerseits und Dickschichtleiterbahnen 56 andererseits. Die (externe) Kontaktierung der jeweiligen Hybridschaltung 8 erfolgt durch Drahtbonden mittels Bonddrähten 71 zwischen Dickschichtleiterbahnen 56 und Kontaktierungsstellen 33 auf der Leiterbahnstruktur 3 und/oder Anschlußkontakten 6. Die durch den Entladewiderstand beim Entladevorgang der gespeicherten Energie abzuführende Verlustleistung beträgt bsp. 50 W, so daß ein Widerstandswert des Entladewiderstands von bsp. 75 Ω benötigt wird; dieser Widerstandswert wird durch Parallelschaltung auf die drei Dickschichtwiderstände 53 der drei Hybridschaltungen 8 als parallel geschaltete Teilwiderstände zu gleichen Teilen aufgeteilt, so daß der Widerstandswert jedes Dickschichtwiderstands 53 als Teilwiderstand somit bsp. 225 Ω beträgt.
Die Verlustleistung der Bauteile 5 des Leistungsumrichters 1 (insbesondere der Leistungsbauteile 51 und der Dickschichtwiderstände 53) wird über den Trägerkörper 2 und den Kühlkörper 41 in den vom Kühlmittel 42, bsp. Wasser oder ein Wasser-Glykol-Gemisch, durchströmten Kühlkreislauf 43 des Kühlsystems 4 abgeführt. Hierzu wird die mit einer Metallisierungsschicht versehene Unterseite 22 des Trägerkörpers 2 auf den bsp. aus Aluminiumsiliziumcarcid (AlSiC) bestehenden, auf seiner Unterseite mit Rauten 44 versehenen Kühlkörper 41 aufgebracht (Dicke des Kühlkörpers 41 bsp. 9 mm); bsp. wird der Trägerkörper 2 auf den Kühlkörper 41 aufgelötet, bsp. in einem gemeinsamen Lötprozeß zusammen mit dem Auflöten der Bauteile 5 auf die Oberseite 21 des Trägerkörpers 2. Elektromotor und Leistungsumrichter 1 benutzen beide bsp. den beim Verbrennungsmotor vorhandenen Kühlkreislauf 43; das Kühlmittel 42 des Kühlkreistaufs 43 wird über den Kühlmittelzulauf 45 durch den Leistungsumrichter 1 geleitet und bsp. auf der gleichen Seite wie der Kühlmittelzulauf 45 oder der Gegenseite des Kühlmittelzulaufs 45 über den Kühlmittelablauf (dieser ist in der Figur 3 nicht dargestellt) in den Kühlkreislauf 43 zurückgeleitet. Die Kühlung des Elektromotors erfolgt bsp. als "Reihenkühlung" im Kühlkreislauf 43 entweder vor oder nach dem Leistungsumrichter 1.
Das Gehäuse 9 des Leistungsumrichters 1 ist dreiteilig ausgebildet mit dem Gehäusemittelteil 91 als Träger, dem Gehäuseoberteil 92 (Gehäusedeckel) und dem zur Energiespeicherung vorgesehenen Kondensator 52, der mit seinem Gehäuse rückseitig an das Gehäusemittelteil 91 und damit in Kontakt mit dem Kühlkreislauf 43 angebracht ist (bsp. angeschraubt ist) und somit das Gehäuseunterteil (den Gehäuseboden) des Leistungsumrichters 1 darstellt. Das Gehäuseoberteil 92 (der Gehäusedeckel) dient zur Abdichtung des Leistungsumrichters 1 und zum Schutz des Leistungsumrichters 1 vor äußeren Einflüssen.

## Patentansprüche

1. Leistungsmodul (1) mit mindestens einem Trägerkörper (2) zur Aufnahme mindestens eines Leistungsbauteils (51) und mit mindestens einem Bauteil (52) als Energiespeicher,
**dadurch gekennzeichnet,**
**daß** auf mindestens einem der Trägerkörper (2) eine Hybridschaltung (8) als Dickschichtschaltung angeordnet ist, die zumindest einen Dickschichtwiderstand (53) als Entladewiderstand zum Entladen des mindestens einen als Energiespeicher vorgesehenen Bauteils (52) aufweist.

2. Leistungsmodul nach Anspruch 1, **dadurch gekennzeichnet, daß** der Entladewiderstand in mindestens zwei parallel geschaltete Teilwiderstände unterteilt ist, und daß die Teilwiderstände als Dickschichtwiderstände (53) in mindestens einer Hybridschaltung (8) auf mindestens einem der Trägerkörper (2) angeordnet sind.

3. Leistungsmodul nach Anspruch 1 oder 2, **dadurch gekennzeichnet, daß** eine Hybridschaltung (8) ein Schaltelement (55) zur Aktivierung des Enladevorgangs zum Entladen des mindestens einen als Energiespeicher vorgesehenen Bauteils (52) aufweist.

4. Leistungsmodul nach Anspruch 3, **dadurch gekennzeichnet, daß** das Schaltelement (55) als Schalttransistor ausgebildet ist.

5. Leistungsmodul nach einem der Ansprüche 1 bis 4, **dadurch gekennzeichnet**, **dadurch gekennzeichnet, daß** mindestens eine Hybridschaltung (8) mindestens einen Sensor (54) aufweist.

6. Leistungsmodul nach Anspruch 5, **dadurch gekennzeichnet**, **dadurch gekennzeichnet, daß** mindestens eine Hybridschaltung (8) einen Temperatursensor (54) zur thermischen Überwachung des mindestens einen Leistungsbauteils (51) aufweist.

7. Leistungsmodul nach einem der Ansprüche 1 bis 6, **dadurch gekennzeichnet, daß** die mindestens eine Hybridschaltung (8) mit der Leiterbahnstruktur (3) auf der Oberseite (21) des Trägerkörpers (2) über Bonddrähte (71) kontaktiert ist.

8. Leistungsmodul nach einem der Ansprüche 1 bis 7, **dadurch gekennzeichnet, daß** der mindestens eine Trägerkörper (2) aus einem isolierenden Material mit hoher Wärmeleitfähigkeit besteht.

9. Leistungsmodul nach Anspruch 8, **dadurch gekennzeichnet, daß** der mindestens eine Trägerkörper (2) aus einem keramischen Material besteht.

10. Leistungsmodul nach einem der Ansprüche 1 bis 9, **dadurch gekennzeichnet, daß** der mindestens eine Trägerkörper (2) auf einem Kühlkörper (41) angeordnet ist.

11. Leistungsmodul nach Anspruch 10, **dadurch gekennzeichnet, daß** der Kühlkörper (41) an ein Kühlsystem (4) angeschlossen ist.

12. Leistungsmodul nach Anspruch 11, **dadurch gekennzeichnet, daß** der Kühlkörper (41) in einen Kühlkreislauf (43) des Kühlsystems (4) integriert ist.

13. Leistungsmodul nach einem der Ansprüche 10 bis 12, **dadurch gekennzeichnet, daß** der Kühlkörper (41) mit der Unterseite (22) des Trägerkörpers (2) über eine Metallisierungsschicht verbunden ist.

14. Leistungsmodul nach einem der Ansprüche 1 bis 13, **dadurch gekennzeichnet, daß** die Leiterbahnstruktur (3) auf der Oberseite (21) des Trägerkörpers (2) Leiterbahnen (31), Aufnahmeflächen (32) zur Aufnahme zumindest der Leistungsbauteile (51), Kontaktierungsstellen (33) zur Kontaktierung zumindest der Leistungsbauteile (51) und Anschlußflächen (34) zur Anbindung von Kontaktierungselementen (71) und/oder von Anschlußkontakten (6) aufweist.

## Claims

1. Power module (1) with at least one carrier body (2) for holding at least one power component (51) and with at least one energy-storing component (52),
**characterized in**
**that** a thick-film hybrid circuit (8) is arranged on at least one of the carrier bodies (2), said thick-film hybrid circuit (8) comprising at least one discharging thick-film resistor (53) for discharging the at least one component (52) provided for storing energy.

2. Power module according to claim 1, **characterized in that** the discharging resistor is divided into at least two sectional resistors connected in parallel and that the sectional resistors are arranged as thick-film resistors (53) in at least one hybrid circuit (8) on at least one of the carrier bodies (2).

3. Power module according to claim 1 or 2, **characterized in that** a hybrid circuit (8) comprises a circuit element (55) for activating the discharge process for discharging the at least one component (52) provided for storing energy.

4. Power module according to claim 3, **characterized in that** the circuit element (55) is configured as a switching transistor.

5. Power module according to any one of claims 1 to 4, **characterized in that** at least one hybrid circuit (8) comprises at least one sensor (54).

6. Power module according to claim 5, **characterized in that** at least one hybrid circuit (8) comprises a temperature sensor (54) for the thermal monitoring of the at least one power component (51).

7. Power module according to any one of claims 1 to 6, **characterized in that** the at least one hybrid circuit (8) is bonded to the track structure (3) on the top (21) of the carrier body (2) via bonding wires (71).

8. Power module according to any one of claims 1 to 7, **characterized in that** the at least one carrier body (2) consists of an insulating material of high thermal conductivity.

9. Power module according to claim 8, **characterized in that** the at least one carrier body (2) consists of a ceramic material.

10. Power module according to any one of claims 1 to 9, **characterized in that** the at least one carrier body (2) is arranged on a heat sink (41).

11. Power module according to claim 10, **characterized in that** the heat sink (41) is connected to a cooling system (4).

12. Power module according to claim 11, **characterized in that** the heat sink (41) is integrated within a cooling circuit (43) of the cooling system (4).

13. Power module according to any one of claims 10 to 12, **characterized in that** the heat sink (41) is connected to the bottom (22) of the carrier body (2) via a metallization layer.

14. Power module according to any one of claims 1 to 13, **characterized in that** the track structure (3) on the top (21) of the carrier body (2) comprises tracks (31), mounting faces (32) for holding at least the power components (51), terminal areas (33) for bonding at least the power components (51), and pads (34) for connecting bonding elements (71) and/or terminals (6).

## Revendications

1. Module de puissance (1) avec au moins un corps support (2) pour loger au moins un composant de puissance (51) et avec au moins un composant (52) en tant qu'accumulateur d'énergie,
**caractérisé en ce que**,
sur au moins un des corps supports (2), est disposé un circuit hybride (8), en tant que circuit à couche épaisse, qui présente au moins une résistance à couche épaisse (53) en tant que résistance de décharge pour la décharge du composant (52), au moins au nombre de un, prévu en tant qu'accumulateur d'énergie.

2. Module de puissance selon la revendication 1, **caractérisé en ce que** la résistance de décharge est divisée en au moins deux résistances partielles montées en parallèle, et **en ce que** les résistances partielles en tant que résistances à couche épaisse (53) sont disposées dans au moins un circuit hybride (8) sur au moins un des corps supports (2).

3. Module de puissance selon la revendication 1 ou 2, **caractérisé en ce qu'**un circuit hybride (8) présente un élément de commutation (55) pour l'activation du processus de décharge pour la décharge du composant (52), au moins au nombre de un, prévu en tant qu'accumulateur d'énergie.

4. Module de puissance selon la revendication 3, **caractérisé en ce que** l'élément de commutation (55) est constitué en tant que transistor de commutation.

5. Module de puissance selon une des revendications 1 à 4, **caractérisé en ce que** au moins un circuit hybride (8) présente au moins un capteur (54).

6. Module de puissance selon la revendication 5, **caractérisé en ce que** au moins un circuit hybride (8) présente un capteur de température (54) pour la surveillance thermique du composant de puissance (51), au moins au nombre de un.

7. Module de puissance selon une des revendications 1 à 6, **caractérisé en ce que** le circuit hybride (8), au moins au nombre de un, est mis en contact avec la structure de pistes conductrices (3) sur le côté supérieur (21) du corps support (2) via des fils de soudure (71).

8. Module de puissance selon une des revendications 1 à 7, **caractérisé en ce que** le corps support (2), au moins au nombre de un, se compose d'un matériau isolant à conductibilité thermique élevée.

9. Module de puissance selon la revendication 8, **caractérisé en que** le corps support (2), au moins au nombre de un, se compose d'un matériau céramique.

10. Module de puissance selon une des revendications 1 à 9, **caractérisé en ce que** le corps support (2), au moins au nombre de un, est disposé sur un dissipateur thermique (41).

11. Module de puissance selon la revendication 10, **caractérisé en que** le dissipateur thermique (41) est raccordé à un système de refroidissement (4).

12. Module de puissance selon la revendication 11, **caractérisé en que** le dissipateur thermique (41) est intégré dans un circuit de refroidissement (43) du système de refroidissement (4).

13. Module de puissance selon une des revendications 10 à 12, **caractérisé en ce que** le dissipateur thermique (41) est raccordé au côté inférieur (22) du corps support (2) via une couche de métallisation.

14. Module de puissance selon une des revendications 1 à 13, **caractérisé en ce que** la structure de pistes conductrices (3) présente, sur le côté supérieur (21) du corps support (2), des pistes conductrices (31), des surfaces de logement (32) pour loger au moins les composants de puissance (51), des points d'établissement de contact (33) pour l'établissement de contact avec au moins les composants de puissance (51), et des surfaces de connexion (34) pour la liaison d'éléments d'établissement de contact (71) et/ou de contacts de connexion (6).
